# EUROPEAN PATENT APPLICATION

(11) **EP 1 959 589 A1**
(43) Date of publication of application: **20.08.2008**
(21) Application number: 08002300.5
(22) Date of filing: 07.02.2008
(51) Int. Cl.: H04B 10/155, H01S 5/06

(54) **Optical transmitting apparatus and temperature controlling method used therefor**

(30) Priority: 14.02.2007 JP 2007032815; 17.10.2007 JP 2007269605
(71) Applicant: NEC Corporation, Minato-ku Tokyo (JP)
(72) Inventor: Yokoyama, Yoshitaka, Minato-ku Tokyo (JP)
(74) Representative: Glawe, Delfs, Moll

(57) **Abstract**

An optical transmitting apparatus includes an optical filter, a port that monitor light transmitted through the optical filter, a port that monitor not light transmitted through the optical filter, an optical waveguide substrate on which the optical filter and an optical waveguide which includes a port that monitors the characteristic of the light which passes through the optical filter, a semiconductor laser and a heater that is capable of independently adjust the wavelength characteristic of any of the optical waveguide and the semiconductor laser, and the optical waveguide substrate and the semiconductor laser are integrated such that the temperature of the optical waveguide substrate and the semiconductor laser can be collectively adjusted.

## Description

### INCORPORATION BY REFERENCE

This application is based upon and claims the benefit of priority from Japanese patent applications No. 2007-032815, filed on February 14, 2007, and No. 2007-269605, filed on October 17, 2007, the disclosure of which is incorporated herein its entirety by reference.

### Field of the Invention

The present invention relates to an optical transmitting apparatus and a temperature controlling method used for the same, and in particular, to a temperature controlling method in an optical transmitting apparatus.

### Description of the Related Art

Various types of small optical transmitting apparatus have been developed in accordance with the recent progress in optical transmitting technique. These small optical transmitting apparatus are required to be adapted for high speed and long distance transmission, which is a trend in big technical innovations. There has so far existed a small optical transmitting apparatus capable of transmitting through a single mode fiber with a length of about 80 km at a bit rate of, for example, 10 Gbps. However, an ordinary non-return to zero (NRZ) modulation system has already reached a wavelength dispersion limit with an increase in bit rate.

On the other hand, various types of modulation systems exceeding the wavelength dispersion limit have been developed, however, a Duo binary modulation system, for example, has a problem with the size, consumption power and cost of the optical transmitting apparatus. A Chirp Managed Laser (CML) modulation system is effective in the above respects but requires further downsizing and cost reduction. The CML modulation system is a technique for controlling a frequency fluctuation at the time of modulating signals to improve transmission characteristics.

As a technique in which size and cost can be reduced by the CML modulation system, the applicant of the present application has proposed a structure in which an optical waveguide substrate and a semiconductor laser are hybrid mounted. However, this structure cannot be adapted to a wavelength division multiplexing (WDM) system which has been a principal system in an optical transmission system in recent years because the implementation of hybrid integration does not enable the wavelength of a semiconductor laser and a wavelength filter to be independently controlled.

Incidentally, a technique as a related art of an optical transmitter is disclosed in the following Patent Document 1 (Japanese Patent Laid-Open No. 2006-313309).

A related optical transmitting apparatus concerned with the above CML modulation system has a problem in that the apparatus is increased in size because the apparatus is configured to separately adjust the temperature of an optical filter and a semiconductor laser and a large number of composing elements is used in the entire optical system including a port for monitoring the transmission characteristics of a filter.

Another related optical transmitting apparatus concerned with the above CML modulation system has a problem in that the stabilization of a specific wavelength adapted to the WDM system cannot be realized when integration is realized because the temperature of the optical filter and the semiconductor laser cannot be independently controlled.

### SUMMARY

An exemplary object of the invention is to provide an optical transmitting apparatus and a temperature controlling method used for the same which are capable of solving the above problems and controlling an oscillation wavelength to a desired value while stabilizing the oscillation wavelength under a predetermined optical modulation conditions (frequency band conditions).

An exemplary aspect of the invention is an optical transmitting apparatus includes an optical filter, a port that monitor light transmitted through the optical filter, a port that monitor not light transmitted through the optical filter, an optical waveguide substrate on which the optical filter and an optical waveguide which includes a port that monitors the characteristic of the light which passes through the optical filter, a semiconductor laser and a heater that is capable of independently adjust the wavelength characteristic of any of the optical waveguide and the semiconductor laser, and the optical waveguide substrate and the semiconductor laser are integrated such that the temperature of the optical waveguide substrate and the semiconductor laser can be collectively adjusted.

Another exemplary aspect of the invention is a temperature controlling method for an optical transmitting apparatus that includes integrating an optical waveguide substrate on which an optical waveguide including an optical filter and ports that monitor light transmitted and not transmitted through the optical filter is formed and a semiconductor laser such that the temperature of the optical waveguide substrate and the semiconductor laser can be collectively adjusted and adding a heater to any of the optical waveguide and the semiconductor laser to independently adjust the wavelength characteristic of any of the optical waveguide and the semiconductor laser.

### BRIEF DESCRIPTION OF THE DRAWINGS

FIG. 1 is a block diagram showing the entire configuration of an optical transmitting apparatus according to a first exemplary embodiment of the present invention;
FIG. 2 is a block diagram showing a control block of the optical transmitting apparatus according to the first exemplary embodiment of the present invention;
FIG. 3 is a schematic view of a modulation signal in the first exemplary embodiment of the present invention;
FIG. 4 is a schematic view of a modulation signal in the first exemplary embodiment of the present invention;
FIG. 5 is a block diagram showing the configuration of an optical transmitting apparatus according to a second exemplary embodiment of the present invention;
FIG. 6 is a block diagram showing a control block of an optical transmitting apparatus according to a third exemplary embodiment of the present invention;
FIG. 7 is a table showing the relationship among control parameters, components to be controlled and objects to be monitored;
FIG. 8 is a block diagram showing the entire configuration of an optical transmitting apparatus according to a fifth exemplary embodiment of the present invention;
FIG. 9 is a block diagram showing an example of a concrete configuration of a wavelength discrimination unit 110 in FIG. 8;
FIG. 10 is a flow chart showing the operation of the optical transmitting apparatus according to the fifth exemplary embodiment of the present invention;
FIG. 11 is a flow chart showing the operation of the optical transmitting apparatus according to the fifth exemplary embodiment of the present invention;
FIG. 12 is a graph showing a monitor signal output characteristic in the fifth exemplary embodiment of the present invention;
FIG. 13 is a graph showing an optical wavelength and optical output characteristic in the fifth exemplary embodiment of the present invention;
FIG. 14 is a graph showing an optical wavelength and optical output characteristic in the fifth exemplary embodiment of the present invention;
FIG. 15 is a graph showing an example of wavelengths set in steady-state operation in the fifth exemplary embodiment of the present invention; and
FIG. 16 is a block diagram showing the entire configuration of an optical transmitting apparatus according to a sixth exemplary embodiment of the present invention.

### EXEMPLARY EMBODIMENT

An exemplary embodiment of the present invention is described below with reference to the drawings.

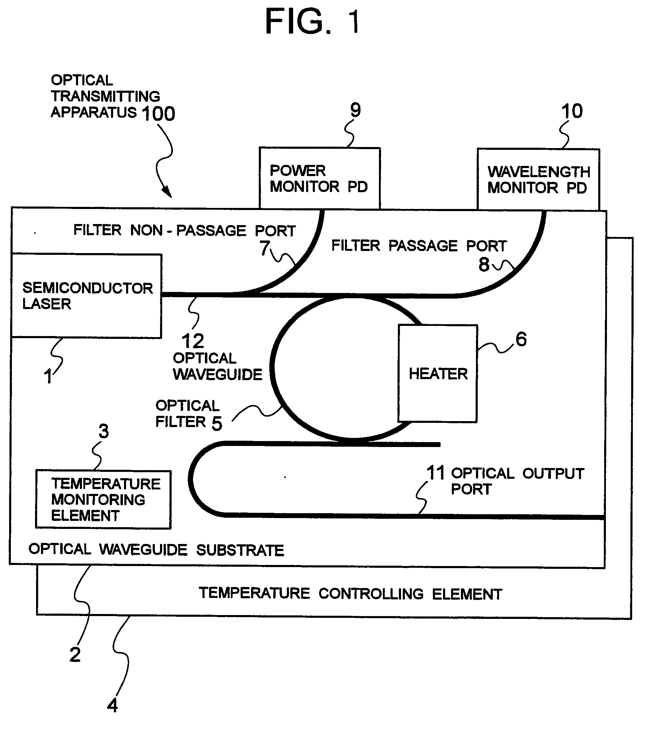

FIG. 1 is a block diagram showing the entire configuration of an optical transmitting apparatus according to a first exemplary embodiment of the present invention.

The optical transmitting apparatus 100 in FIG. 1 includes the semiconductor laser 1, the optical waveguide substrate 2, a temperature monitoring element 3, a temperature controlling element 4, an optical filter 5, the heater 6, a power monitor PD (photo diode) 9, and a wavelength monitor PD 10. The optical waveguide 12 is formed on the optical waveguide substrate 2 and includes a filter non-passage port 7, a filter passage port 8 and an optical output port 11.

The bias current of the semiconductor laser 1 is modulated under an appropriate condition to modulate the output frequency thereof. The semiconductor laser 1 is mounted on the optical waveguide substrate 2 so that the modulated optical signal is coupled to the optical waveguide 12 on the optical waveguide substrate 2. The optical signal is passed through the optical filter 5 to be limited to an appropriate frequency component and output from the optical output port 11 as a main signal.

Limiting the optical signal to an appropriate frequency component as described above enables the transmission of light with a wavelength band of 1550 nm at a modulation rate of 10 Gbps, for example, through an ordinary single mode fiber over a distance of 100 km or longer. Typically, an optical isolator is fixed to the outlet of the optical output port 11 to be coupled to an optical fiber with use of a lens (which are not shown).

One part of the optical signal in the optical waveguide 12 is output to the filter non-passage port 7 and its intensity is received by the power monitor PD 9. Furthermore, another part of an optical signal in the optical waveguide 12 is passed though the optical filter 5 and then output to the filter passage port 8 and its strength is received by the wavelength monitor PD 10.

Where, Δ λ is defined as a difference between the oscillation wavelength λ LD of the semiconductor laser 1 and the center wavelength λ Filter of the optical filter 5. The power monitor PD 9 receives a signal independent of Δ λ and the wavelength monitor PD 10 receives a signal which changes depending on Δ λ.

As described later, Δ λ is constantly controlled using the monitor signals to obtain a stable optical modulation characteristic.

The optical waveguide substrate 2 is capable of monitoring temperature through the temperature monitoring element 3. The entire optical waveguide substrate 2 is mounted on the temperature controlling element 4 and the temperature controlling element 4 is capable of controlling the temperature of the entire substrate. The temperature of the heater 6 is controlled to adjust the center wavelength λ Filter of the optical filter 5.

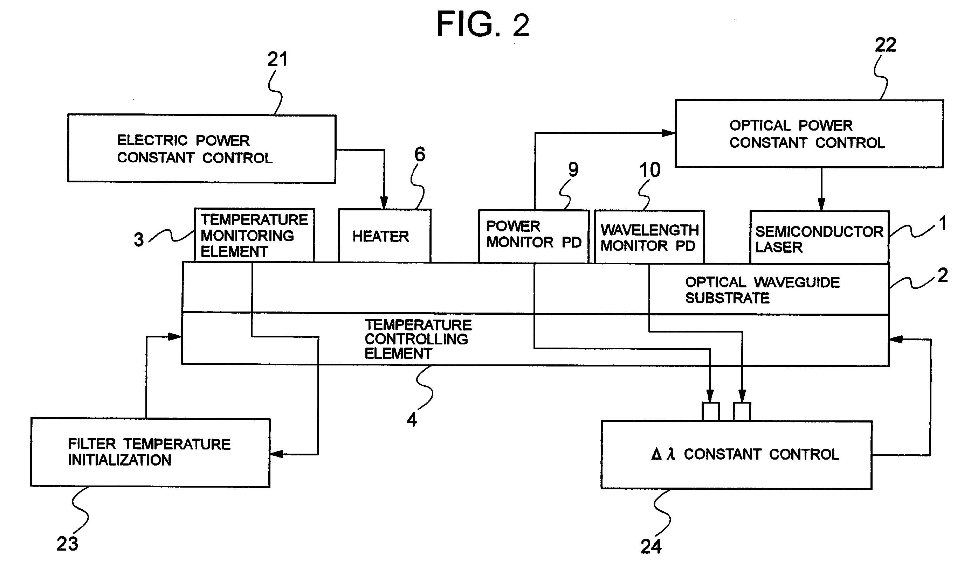

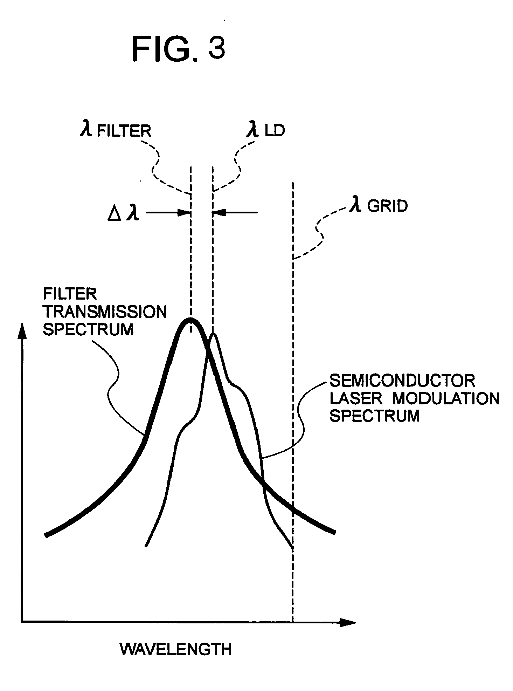

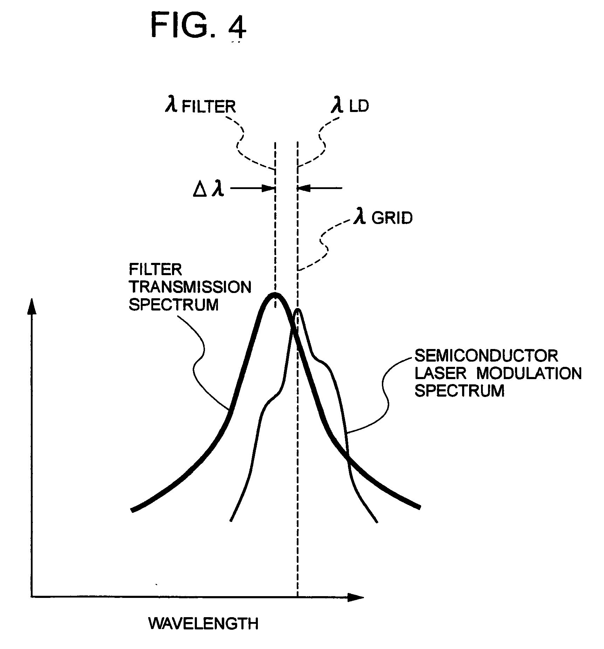

FIG. 2 is a block diagram showing of a control block of the optical transmitting apparatus according to the first exemplary embodiment of the present invention. FIGS. 3 and 4 are schematic views of modulation signals in the first exemplary embodiment of the present invention. Referring to FIGS. 2 to 4, the operation of the optical transmitting apparatus 100 according to the first embodiment of the present invention is described.

As stated above, the modulation signal is provided for the semiconductor laser 1, limited in frequency band by the optical filter 5 so that the modulation signal can be adapted to a long distance optical transmission and output from the optical output port 11. The operation related to the control of wavelength of the semiconductor laser 1 and the optical filter 5 is described herein.

The bias current of the semiconductor laser 1 is feedback controlled so that the value of the power monitor PD 9 can be kept constant (Optical power constant control 22 in FIG. 2).

The optical waveguide substrate 2 feeds temperature information back to the temperature controlling element 4 so that the temperature of the temperature monitoring element 3 can be kept at a predetermined temperature to perform a temperature constant control (filter temperature initialization 23 in FIG. 2).

The heater 6 is controlled to be kept constant at a predetermined electric power (electric power constant control 21 in FIG. 2). Since the heater 6 performs a local temperature control, it is difficult for the heater 6 to perform an appropriate temperature monitor, so that the heater 6 desirably performs control which makes an input electric power constant.

Although stable control is basically enabled in this condition, Δ λ previously defined needs to be stabilized at an extremely high accuracy in the optical transmitting apparatus 100 shown in FIG. 1, so that control is required by which a slight shift of Δ λ caused when environmental temperature changes or after the apparatus has operated for a long time period is detected and fed back.

To satisfy the above, the outputs of the power monitor PD 9 and the wavelength monitor PD 10 are used to fed back to the temperature controlling element 4 so that the ratio of both outputs can be kept constant (Δ λ constant control 24 in FIG. 2), thereby performing switching to control the temperature of the optical waveguide substrate 2.

For a system which does not need controlling an output wavelength to a predetermined value, only Δ λ may be stably controlled and the oscillation wavelength λ LD of the semiconductor laser 1 does not need to be controlled to a predetermined value, so that there is no need of providing the electric power constant control for the heater 6. FIG. 3 shows the above description. The oscillation wavelength λ LD of the semiconductor laser 1 changes depending on the center wavelength λ Filter of the optical filter 5.

For the WDM system which needs controlling the oscillation wavelength λ LD of the semiconductor laser 1 to a predetermined value, the oscillation wavelength λ LD of the semiconductor laser 1 needs to be adjusted to a specific wavelength grid, so that the center wavelength λ Filter of the optical filter 5 needs to be adjusted in advance to be constantly controlled to the value.

For this reason, the present embodiment implements stable control of the heater 6 for controlling the local temperature of the optical filter 5 of the optical waveguide substrate 2. This implementation stabilizes the oscillation wavelength λ LD of the semiconductor laser 1 to a predetermined grid wavelength with the oscillation wavelength λ LD of the semiconductor laser 1 stably controlled to suit a predetermined optical output condition, as shown in FIG. 4.

Thus, the first exemplary advantage according to the invention is that the collective temperature control of the entire optical waveguide substrate 2 on which the semiconductor laser 1 is mounted and the independent temperature control of the local part of the optical filter 5 of the optical waveguide 12 enable the semiconductor laser 1 and the optical filter 5 to be integrated and the oscillation wavelength can be controlled to a desired value while being stabilized under a predetermined optical modulation conditions (frequency band conditions).

In the first exemplary embodiment, integrating the semiconductor laser 1 with the optical filter 5 allows decreasing the number of composing elements and collectively controlling the temperature of the entire optical waveguide substrate 2 to enable the optical transmitting apparatus 100 to be downsized.

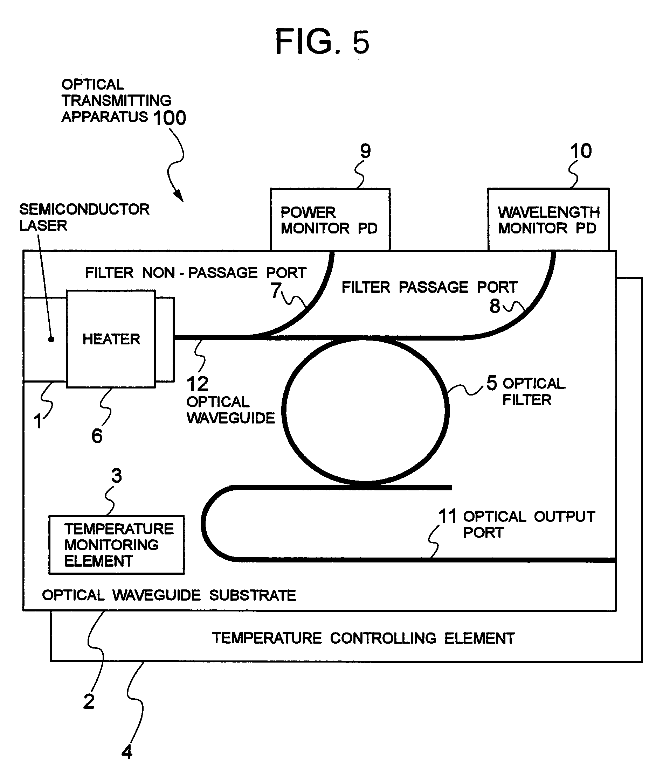

FIG. 5 is a block diagram showing the configuration of an optical transmitting apparatus according to a second exemplary embodiment of the present invention. The second exemplary embodiment of the present invention is the same in configuration as the first exemplary embodiment of the present invention shown in FIG. 1, except that the heater 6 is formed on the semiconductor laser 1 instead of forming the heater 6 at the portion of the optical filter 5 of the optical waveguide substrate 2. The same composing elements are given the same reference numerals. The same composing elements operate in the same manner as those in the first exemplary embodiment.

As is the case with the first exemplary advantage, the second exemplary advantage according to the invention is that since the semiconductor laser 1 and the optical fiber 5 are integrated and the collective temperature control of the entire optical waveguide substrate 2 on which the semiconductor laser 1 is mounted and the independent temperature control of the local part of the semiconductor laser 1 are executed, the oscillation wavelength can be controlled to a desired value while being stabilized under a predetermined optical modulation conditions (frequency band conditions).

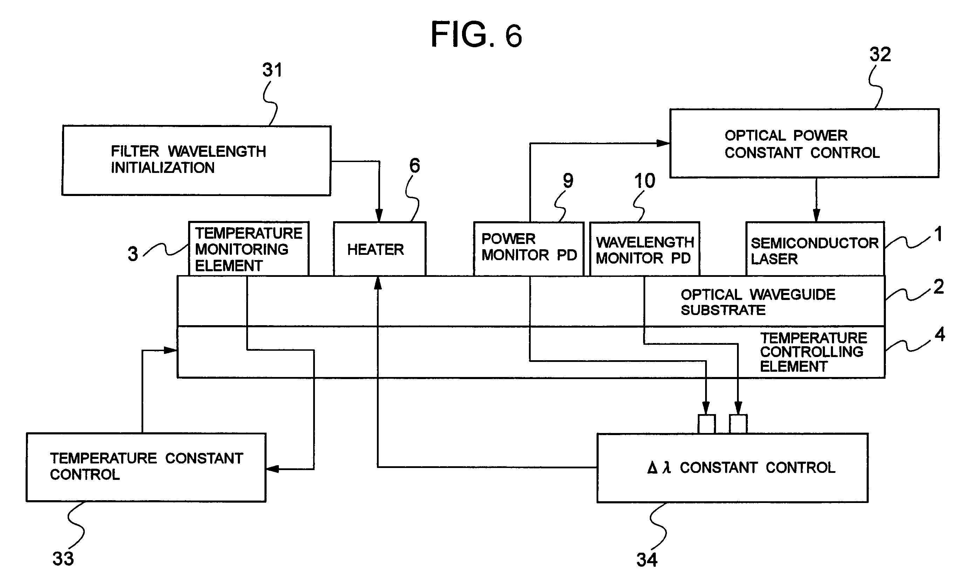

FIG. 6 is a block diagram showing a control block of an optical transmitting apparatus according to a third exemplary embodiment of the present invention. The optical transmitting apparatus 100 according to the third exemplary embodiment of the present invention is the same in configuration as that according to the first exemplary embodiment of the present invention, except that the control blocks 31 to 34 are different from those in the third exemplary embodiment of the present invention described above. The operation of the optical transmitting apparatus 100 according to the third exemplary embodiment of the present invention is described below with reference to FIG. 6.

As stated above, the modulation signal is provided for the semiconductor laser 1, limited in frequency band by the optical filter 5 so that the modulation signal can be adapted to a long distance optical transmission and output from the optical output port 11. The operation related to the control of wavelength of the semiconductor laser 1 and the optical filter 5 is described herein.

The bias current of the semiconductor laser 1 is feedback controlled so that the value of the power monitor PD 9 can be kept constant (Optical power constant control 32 in FIG. 6).

The optical waveguide substrate 2 feeds temperature information back to the temperature controlling element 4 so that the temperature of the temperature monitoring element 3 can be kept at a predetermined temperature to perform a temperature constant control of the temperature controlling element 4 using the temperature monitoring element 3 to initialize filter temperature for the temperature constant control (temperature constant control 33 in FIG. 6).

The heater 6 is controlled to be kept constant at a predetermined electric power (filter wavelength initialization 31 in FIG. 6).

In the third exemplary embodiment, an electric power applied to the heater 6 is controlled using the outputs of the power monitor PD 9 and the wavelength monitor PD 10 so that a wavelength difference Δ λ between the semiconductor laser 1 and the optical filter 5 is kept constant (switching from temperature control using the temperature monitoring element 3) (Δ λ constant control 34 in FIG. 6).

Furthermore, in the third exemplary embodiment, the setting temperature of the temperature monitoring element 3 for monitoring the temperature of the temperature controlling element 4 is adjusted to the WDM grid to obtain an appropriate output wavelength (continuing the temperature constant control using the temperature monitoring element 3 in FIG. 6).

The third exemplary advantage according to the invention is that since the semiconductor laser 1 and the optical fiber 5 are integrated and the collective temperature control of the entire optical waveguide substrate 2 on which the semiconductor laser 1 is mounted and the independent temperature control of the local part of the optical filter 5 of the optical waveguide 12 or of the semiconductor laser 1 are executed, the oscillation wavelength can be controlled to a desired value while being stabilized under a predetermined optical modulation conditions (frequency band conditions).

A fourth exemplary embodiment of the present invention is described below. The optical transmitting apparatus in the fourth exemplary embodiment of the present invention is the same in configuration as that in the second exemplary embodiment of the present invention shown in FIG. 5. Temperature is controlled in the same manner as in the third exemplary embodiment of the present invention shown in FIG. 6.

The fourth exemplary advantage according to the invention is that since the semiconductor laser 1 and the optical fiber 5 are integrated and the temperature control of the local part of the semiconductor laser 1 instead of the temperature control of the local part of the optical filter 5 of the optical waveguide 12 as described in the third exemplary embodiment of the present invention is executed, the oscillation wavelength can be controlled to a desired value while being stabilized under a predetermined optical modulation conditions (frequency band conditions) as is the case with the above.

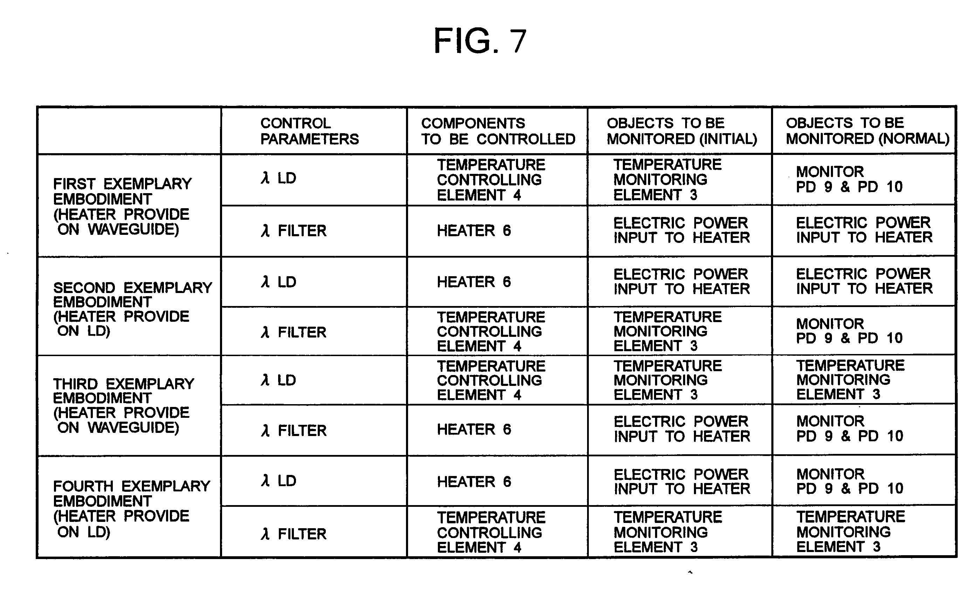

FIG. 7 is a table showing the relationship among control parameters, components to be controlled and objects to be monitored in the first to the fourth exemplary embodiment of the present invention. As shown in FIG. 7, in the present invention, the temperature controlling element 4 controls the entire optical waveguide substrate 2 and the heater 6 locally controls part of the optical filter 5 of the optical waveguide 12 or part of the semiconductor laser 1.

For this reason, in the present invention, the semiconductor laser 1 and the optical filter 5 can be integrated and the oscillation wavelength can be controlled to a desired value while being stabilized under a predetermined optical modulation conditions (frequency band conditions).

That is to say, in the first to the fourth exemplary embodiment of the present invention, the optical transmitting apparatus 100 includes the optical filter 5, the port for monitoring light passing through the optical-filter (filter passage port 8), the port for monitoring light not passing through the optical filter (filter non-passage port 7), the optical waveguide substrate 2 on which the above components are formed, the monitor PDs arranged on respective monitor ports (or the power monitor PD 9 and the wavelength monitor PD 10), the semiconductor laser 1, the temperature monitoring element 3, the heater 6 formed on the optical filter 5 or the semiconductor laser 1 and the temperature adjusting element (temperature controlling element 4).

The optical transmitting apparatus 100 integrates the substrate (or the optical waveguide substrate 2) on which the optical waveguide including the optical filter 5 and the port for monitoring a filter transmission characteristic is formed with the semiconductor laser 1 such that the temperature of the substrate and the semiconductor laser 1 can be collectively adjusted and adds the heater 6 capable of independently adjusting the wavelength characteristics of the optical waveguide or the semiconductor laser 1. This permits an optical output wavelength to be stabilized at a specific wavelength and the frequency band of a semiconductor-laser modulation spectrum to be limited by the optical filtering, thereby allowing a long-distance optical fiber transmission adapted for the WDM system at a high bit rate.

The optical transmitting apparatus of the present invention may be provided with the heater 6 formed on the optical waveguide substrate 2 which is wavelength characteristic adjusting means of the optical filter 5, instead of the heater 6 formed on the semiconductor laser 1.

The application of the modulation system related to the present invention to Dense Wavelength Division Multiplexing (DWDM) system requires an optical output and optical wavelength characteristic capable of suppressing the influence on adjacent wavelength channels at the time of starting the optical transmitting apparatus.

Specifically, it is required to suppress the generation of an optical output which is greater than a specified value at the time of starting and different in wavelength from the specified value.

However, in the above optical transmitting apparatus related to the present invention, the semiconductor laser being the light source of the optical transmitting apparatus has such a characteristic that the wavelength of optical output is basically lengthened with the increase in injection current. For this reason, the wavelength of the optical output fluctuates corresponding to an increase in the optical output when current is increased from zero so as to obtain a specified optical output at the time of starting the semiconductor laser. Therefore, the wavelength of the optical output in the optical transmitting apparatus used in the DWDM system fluctuates at the time of starting, which makes it difficult to decrease the optical output outside of a specified optical wavelength. This may adversely affects adjacent optical wavelength channel.

In the optical transmitting apparatus related to the present invention, there exists a method in which a variable optical attenuator is mounted on the optical output portion of the optical transmitting apparatus to solve the above problem. This, however, poses a problem in that a significant loss is caused in the optical output, the apparatus is increased in size and control is complicated.

This is because it is not easy to realize such a variable attenuator that can be mounted in a package of a small optical module which has been currently used in a general optical transmitting apparatus and because, even if the variable attenuator was realized, the apparatus would be increased in size, or even if the attenuator could be mounted, a component and a controlling function for monitoring and controlling the optical output intensity of the attenuator would be additionally required to stably control the optical output intensity. Furthermore, it is unavoidable to suffer an insertion loss of the optical attenuator in itself and an optical loss in the above optical output monitoring system.

This is also because it is difficult to stably transmit light through a general optical fiber with a length of 80 km or longer at a transmission rate of, for example, 10 Gbps in the optical transmitting apparatus related to the present invention.

The reason is that increasing a modulation rate to as high as 10 Gbps substantially widens an optical spectral band output from a general optical transmitting apparatus and an optical transmission signal waveform is influenced by wavelength dispersion in the optical fiber to be degraded.

To solve these problems, in the optical transmitting apparatus of the present invention, the optical output wavelength is initialized at the time of starting the optical transmitting apparatus to the wavelength longer than the optical output wavelength set in the steady state, thereby enabling the output of the semiconductor laser to reach a specified optical output and to be brought into a normal operation condition without generating an optical output momentarily and significantly exceeding the specified value when the semiconductor laser starts outputting.

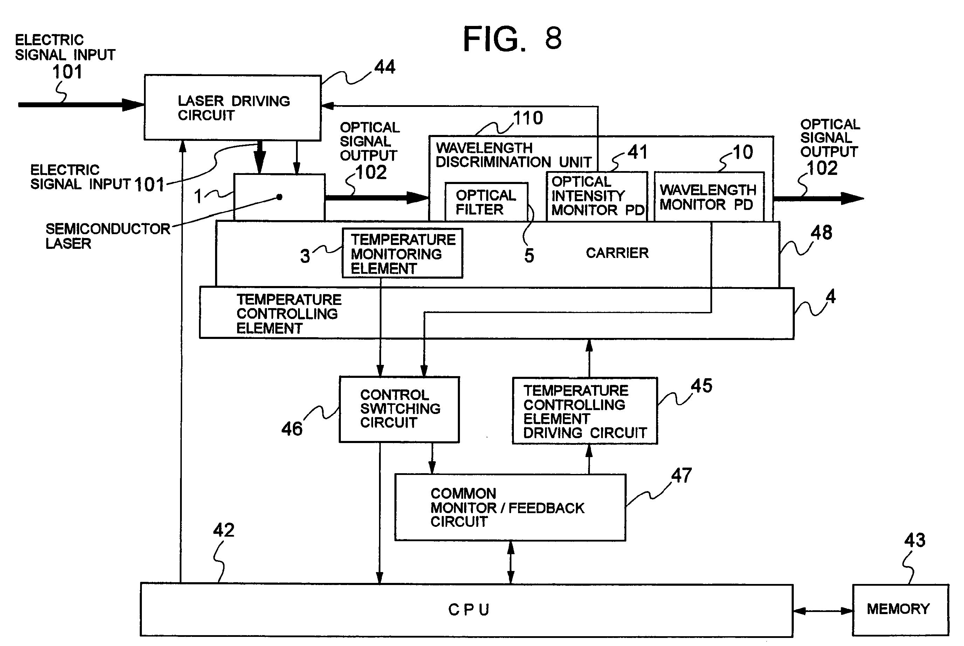

A fifth exemplary embodiment is described below. FIG. 8 is a block diagram showing the entire configuration of an optical transmitting apparatus according to the fifth exemplary embodiment of the present invention. In FIG. 8, the optical transmitting apparatus according to the fifth exemplary embodiment of the present invention includes the semiconductor laser 1, the wavelength discrimination unit 110, the temperature monitoring element 3, the temperature controlling element 4, the optical filter 5, the optical intensity monitor PD 41, the wavelength monitor PD 10, a central processing unit (CPU) 42, a memory 43, a laser driving circuit 44, a temperature controlling element driving-circuit 45, a control switching circuit 46, a common monitor/feedback circuit 47 and a carrier 48. In FIG. 8, reference numeral 101 denotes an electric signal input; 102, an optical signal output.

The laser driving circuit 44 applies bias current and modulation current to the semiconductor laser 1. The laser driving circuit 44 converts a signal according to the electric signal input 101 to a current amplitude specified by the CPU 42.

In addition, the laser driving circuit 44 controls the bias current of the semiconductor laser 1 so that a photo current of the optical intensity monitor PD 41 in front of the semiconductor laser 1 can be equal to a value specified by the CPU 42. Thus, the constant bias provides the constant modulation signal through these operations in the seventh exemplary embodiment.

The optical signal output 102 from the semiconductor laser 1 passes through the wavelength discrimination unit 110. At this point, an optical spectrum is limited by the optical filter 5 in the wavelength discrimination unit 110.

As a result, the present invention suppresses the expansion of the modulation spectrum even at a higher transmission rate, providing a high wavelength-dispersion resistance to enable an optical fiber transmission over a distance of as long as 80 km or more, for example.

Since the wavelength monitor PD 10 in the wavelength discrimination unit 110 can monitor the optical output wavelength of the semiconductor laser 1 and the relative wavelength of the optical filter 5 under the condition that the photo current of the optical intensity monitor PD 41 is kept constant, the temperature of the carrier 48 is controlled with use of the common monitor/feedback circuit 47, the temperature controlling element driving-circuit 45 and the temperature controlling element 4, thereby constantly controlling the relative wavelength of the optical filter 5 to provide a stable optical output characteristic.

The semiconductor laser 1 used herein is a distributed feedback (DFB) laser with a wavelength of 1550 nm and the optical filter 5 is formed from quartz material. Assuming a general situation, the temperature characteristic of the semiconductor laser 1 and the optical filter 5 is about 0.1 nm/°C and 0.01 nm/°C respectively, that is, the temperature characteristic of the semiconductor laser 1 is 10 times as high as that of the optical filter 5, so that adjusting the temperature of the carrier 48 adjusts the wavelength of the semiconductor laser 1 with respect to that of the optical filter 5.

However, the above temperature controlling method cannot be realized unless there exists the optical output from the semiconductor laser 1, so that the temperature controlling element 4 is controlled with use of the signal of the temperature monitoring element 3 at the time of starting the semiconductor laser 1 after it has been turned off.

After that, the semiconductor laser 1 is turned on, a monitoring signal is switched by the control switching circuit 46 when the optical output is provided to perform temperature control using the optical wavelength monitor PD 10. This is performed by the instruction of the CPU 42. Target setting values of the temperature controlling element 4 and the wavelength monitor PD 10 are stored in the memory 43.

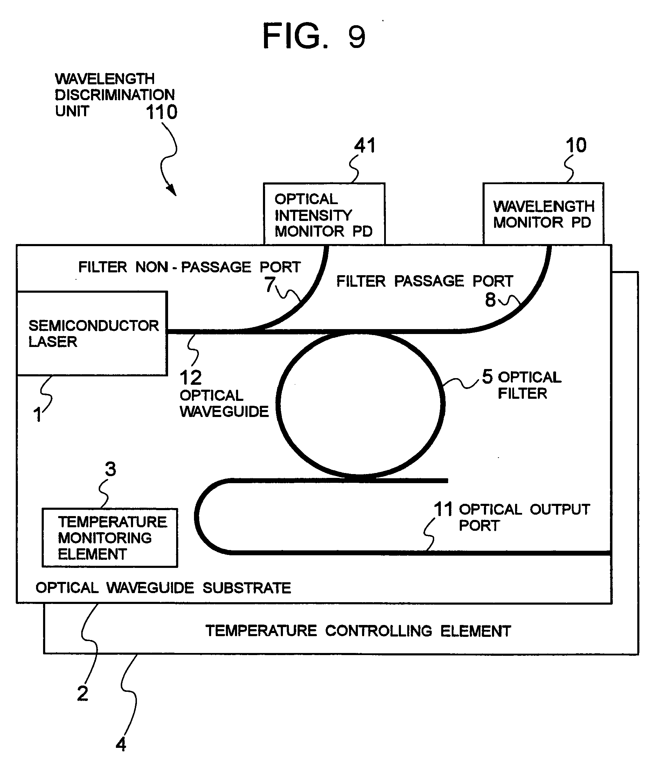

FIG. 9 is a block diagram showing an example of a concrete configuration of the wavelength discrimination unit 110 in FIG. 8. In FIG. 9, the optical waveguide 12 and optical filter 5 are formed on the optical waveguide substrate 22, so that the optical waveguide substrate 2 also serves as the above carrier 48.

An optical branch can be easily formed in the optical waveguide 12, so that the filter non-passage port 7 and the filter passage port 8 can be formed. This provides a monitor signal required for controlling the semiconductor laser 1 as describe above and an optical signal whose band is limited by the optical filter 5 from the optical output port 11.

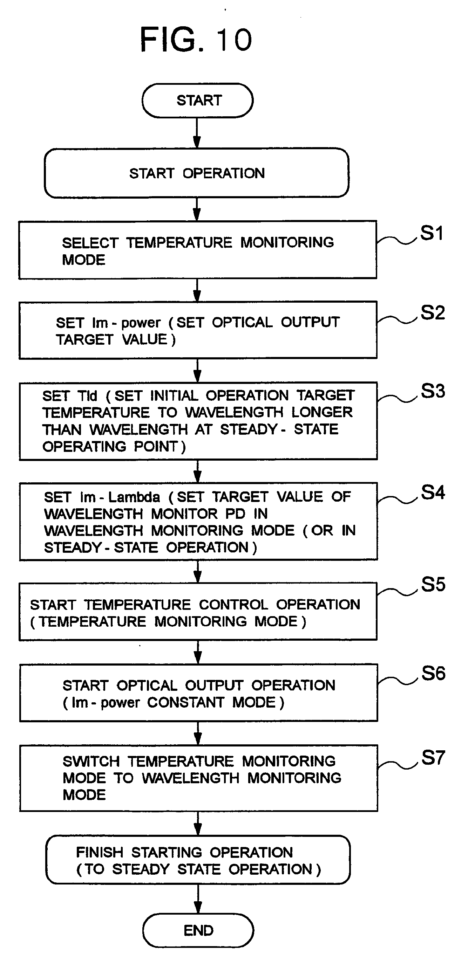

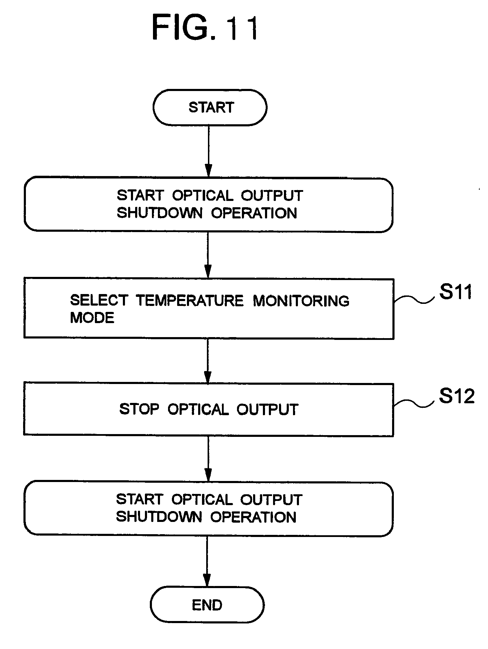

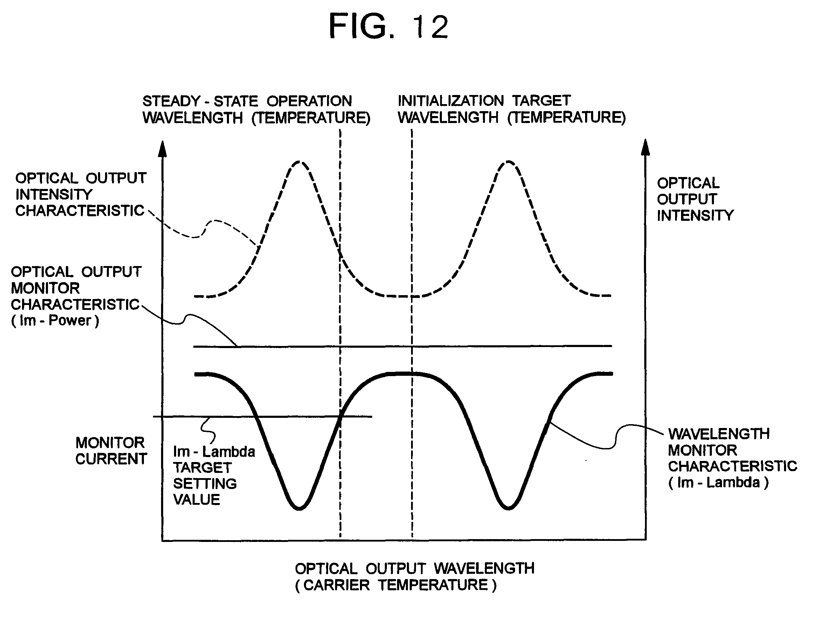

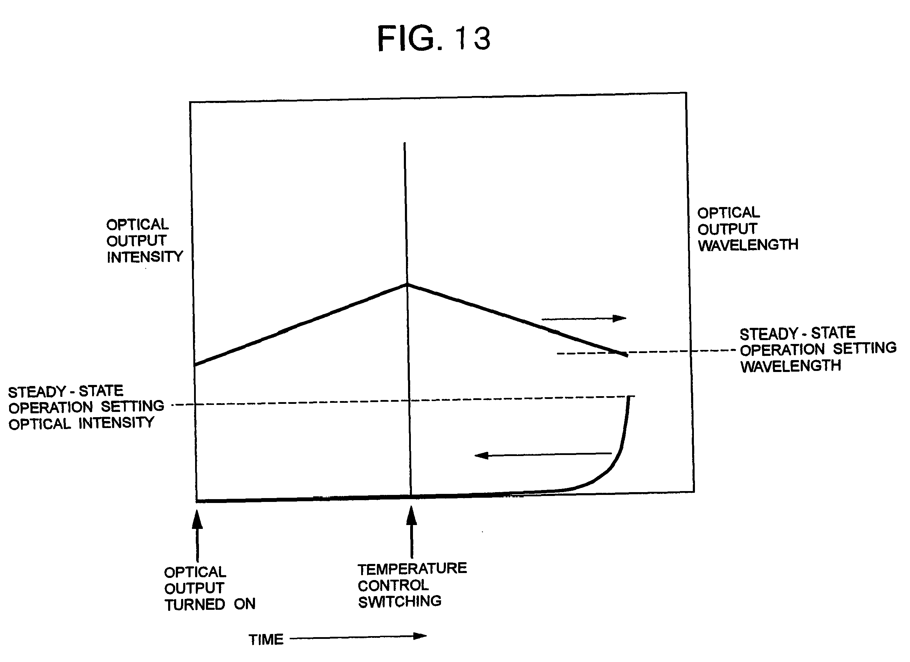

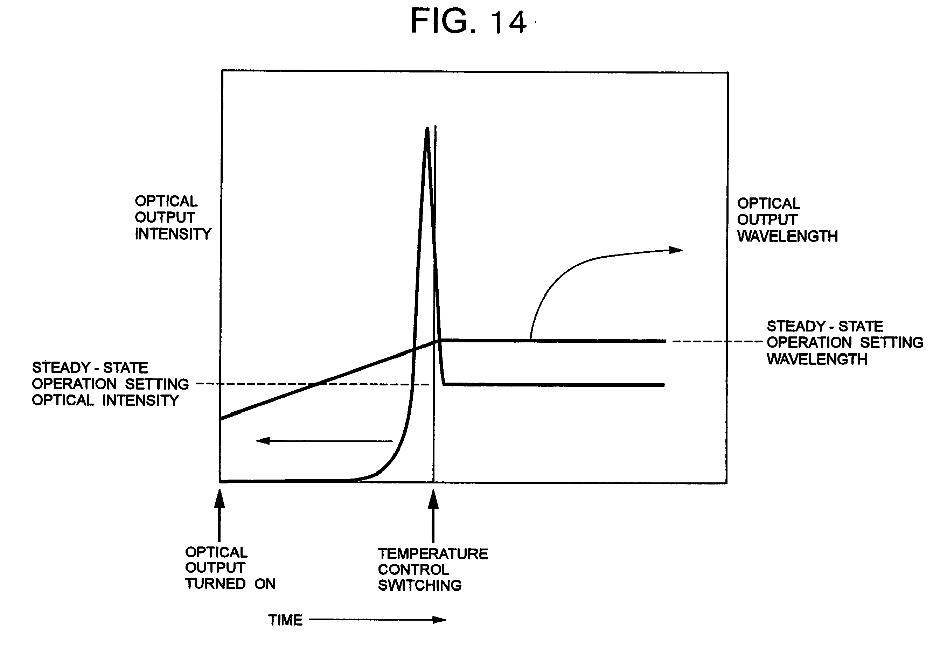

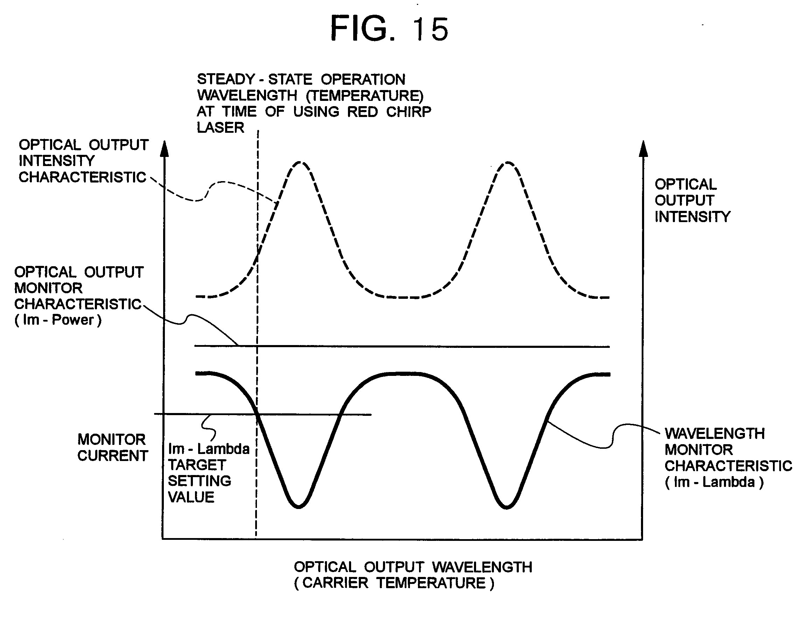

FIGS. 10 and 11 are flow charts showing the operation of the optical transmitting apparatus according to the fifth exemplary embodiment of the present invention. FIG. 12 is a graph showing the monitor signal output characteristics in the fifth exemplary embodiment of the present invention. FIGS. 13 and 14 are graphs showing optical wavelength/optical output characteristic in the fifth exemplary embodiment of the present invention. FIG. 15 is a graph showing an example of a wavelength set in the steady-state operation in the fifth exemplary embodiment of the present invention. The operation of the control method of the optical transmitting apparatus according to the fifth exemplary embodiment of the present invention is described with reference to FIGS. 9 to 16.

In the steady state, a bias current in the semiconductor laser 1 is controlled so that the photo current (defined as Im-Power) of the optical intensity monitor PD 41 is kept constant and the temperature (Tld) of the carrier 48 on which the semiconductor laser 1 is mounted is controlled so that the photo current (defined as Im-Lambda) of the wavelength monitor PD 10 is kept constant.

FIG. 12 is a schematic view showing the photo current characteristics of the monitors and the dependence of the optical output intensity of the optical transmitting apparatus on wavelength. In FIG. 12, although the abscissa is an optical output wavelength, the optical output wavelength is proportional to a carrier temperature, so that it may be regarded as a carrier temperature. As can be seen from the graph, the obtained optical output monitor characteristic is independent of the wavelength and the wavelength monitor characteristic and optical output intensity characteristic are dependent on the shape of the optical filter 5.

In the optical transmitting apparatus according to the fifth exemplary embodiment of the present invention, as shown in the steady-state operation wavelength in FIG. 12, it is desirable to set a wavelength on a slope on the longer wavelength side than the wavelength at the peak viewed in the optical output characteristic to obtain a satisfactory optical signal characteristic. Eventually, the temperature of the carrier is so controlled as to be equal to the value shown in the Im-Lambda target setting value to obtain the operation wavelength set in the steady state.

FIG. 10 is a flow chart showing the starting operation of the semiconductor laser 1. Since the optical output needs to be turned off, the CPU 42 selects a mode for controlling the temperature of the carrier as a mode for monitoring temperature using the signal of the temperature monitoring element 3 (step S1 in FIG. 10).

After that, the CPU 42 sets the Im-Power which is the target value of the optical output (step S2 in FIG. 10).

Actually, the CPU 42 reads the setting value stored in advance in the external memory 43.

The CPU 42 sets the temperature Tld to the wavelength longer than the wavelength at the steady-state operating point, as shown in the initialized target wavelength in FIG. 12 (step S3 in FIG. 10).

After that, the CPU 42 starts the operation of the temperature monitoring element 3 in the temperature monitoring mode (steps S4 and S5 in FIG. 10), and then starts optical output operation in an Im-Power constant mode (step S6 in FIG. 10).

Since the bias current of the semiconductor laser 1 increases from zero to a specified value, the optical output increases and the optical output wavelength fluctuates.

However, in the fifth exemplary embodiment, the wavelength is initialized to the wavelength longer than the wavelength set in the steady state, so that the optical output wavelength is passed through not the peak of the filter but the vicinity of bottom of the filter when the optical output wavelength fluctuates, as a result, the optical output is suppressed to the vicinity of a level zero.

The CPU 42 switches the temperature monitoring mode to the wavelength monitoring mode (step S7 in FIG. 10) to adjust the operation wavelength from the vicinity of bottom of the filter to the steady-state operation point in the vicinity of slope of the filter. The effect of the optical filter 5 increases the optical output only in the vicinity of the optical wavelength at the steady-state operation point and the optical output reaches the specified value. The schematic view of change in optical output and optical wavelength at this point is shown in FIG. 13.

Provisionally initializing the wavelength to the same value as in the steady state causes the optical wavelength to pass the peak of the filter after the semiconductor laser 1 has been turned on, generating the optical output significantly exceeding the optical output in the steady state operation, as shown in FIG. 14. This may hinder the optical transmitting system on which the optical transmitting apparatus is mounted from being stably started, requiring such an operation method as not to generate such a significant optical output.

FIG. 11 is a flow chart showing an operation in which the optical output of the optical transmitting apparatus is turned off at the time of sounding the alarm on the optical transmitting system. The CPU 42 switches the wavelength monitoring mode to the temperature monitoring mode (step S11 in FIG. 11) to stop the optical output (step S12 in FIG. 11). If the optical output is stopped in wavelength monitoring mode, there does not exist a monitoring signal for controlling temperature, which does not enable the temperature controlling element 4 to be controlled.

Thus, the fifth exemplary advantage according to the invention is that mounting the optical filter 5 for limiting an optical spectral band on the optical transmitting apparatus so as to obtain the optical output only in the vicinity of a specified optical wavelength enables the optical output at the time of starting to be obtained only in the vicinity of the specified operation wavelength, that is to say, enables the optical output to be reduced outside of the specified wavelength in the optical transmitting apparatus used in the Dense Wavelength Division Multiplexing (DWDM) system, allowing suppressing the influence on the adjacent optical wavelength channel.

In the fifth exemplary embodiment, the wavelength is initialized to the wavelength longer than the wavelength set in the steady state, thereby causing the optical output at the time of starting to pass the vicinity of bottom of the filter to suppress the optical output to the optical intensity in the vicinity of the level zero, permitting suppressing the momentary generation of an optical output greater than the specified value.

Furthermore, in the fifth exemplary embodiment, the optical spectrum is limited by the optical filter 5 at the time of modulation to enable suppressing a waveform degradation under the influence of wavelength dispersion in the optical fiber, allowing realizing the optical transmitting apparatus which stably implements an optical fiber transmission with a high transmission rate and over a long distance.

Still furthermore, in the fifth exemplary embodiment, the optical filter 5 for stabilizing the characteristic of the optical output signal can be caused to serve to stabilize also the optical wavelength/optical output characteristic at the time of starting, eliminating the need for mounting an additional variable optical attenuator or an optical output monitoring device therefor, which allows downsizing the optical transmitting apparatus which possesses the above high transmission capability and suppresses the influence on adjacent wavelength channels at the time of starting.

In the fifth exemplary embodiment described above, a general DFB laser is presumed to be used as the semiconductor laser 1. At that point, in the case where a modulation signal corresponds to "0" to "1" there exists the effect of adiabatic chirp that a wavelength shifts from a long wavelength to a short wavelength. Setting the wavelength of the semiconductor laser 1 midway along the slope on the long wavelength side of the optical filter 5 such that part of the optical spectrum corresponding to the "0" is cut off provides a satisfactory optical transmission waveform.

While it is described that a wavelength is shifted toward a longer wavelength side as current is injected at the time of starting the semiconductor laser 1, in other words, there exists the characteristic that the direction in which the wavelength is shifted is reversed depending on operation frequencies. This may cause a problem when lower frequency signals are transmitted. As one of means of avoiding the problem, a red-chirp semiconductor laser may be applied in which a short wavelength is changed to a long wavelength when "0" is changed to "1" even at the time of a high speed modulation.

In this case, the slope on the shorter wavelength side of peak of the filter is set to the operation wavelength set in the steady state as shown in FIG. 15. The application of the red-chirp semiconductor laser fundamentally provides the same effect as in the first exemplary embodiment of the present invention stated above, but only a difference is that the wavelength is initialized not to the wavelength longer than the wavelength set in the steady state, but to the same wavelength as in the steady state or to the wavelength shorter than that in the steady state. This provides an appropriate optical output and optical wavelength characteristic.

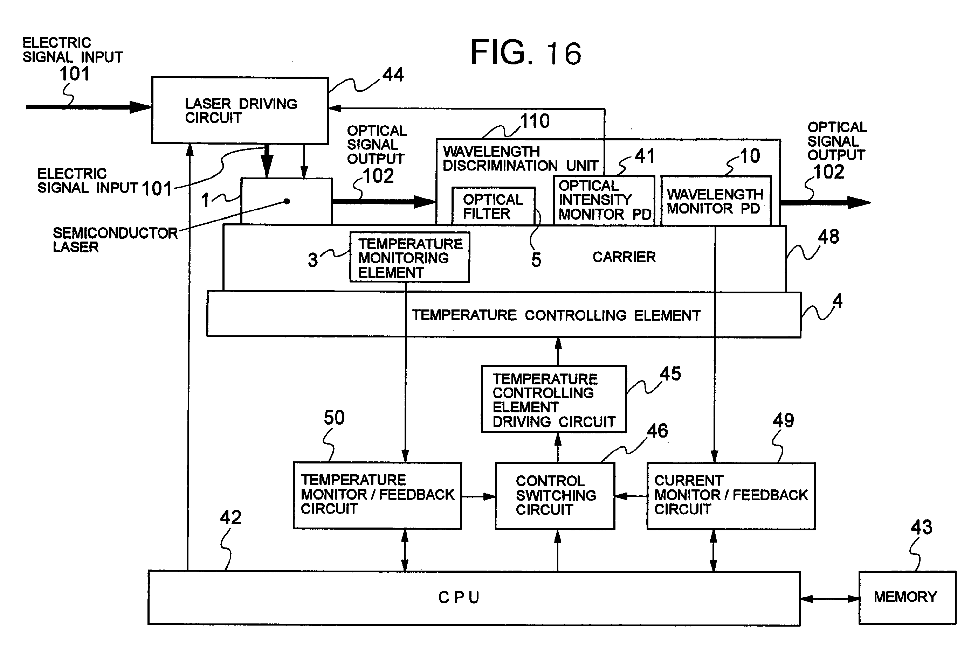

FIG. 16 is a block diagram showing the entire configuration of an optical transmitting apparatus according to a sixth exemplary embodiment of the present invention. In FIG. 16, the optical transmitting apparatus according to the sixth exemplary embodiment of the present invention is the same in configuration as the optical transmitting apparatus according to the fifth exemplary embodiment of the present invention shown in FIG. 8 except that a current monitor/feedback circuit 49 and a temperature monitor/feedback circuit 50 are provided instead of the common monitor/feedback circuit 47. The same composing elements are given the same reference numerals.

In the example showing in FIG. 8, while the signals of the temperature monitoring element 3 and the wavelength monitor PD 10 are selected by the control switching circuit 46 and then introduced to the common monitor/feedback circuit 47, the signals of the temperature monitoring element 3 and the wavelength monitor PD 10 may be separately received by a temperature monitor/feedback circuit 50 and a current monitor/feedback circuit 49 respectively and the control signal output to the temperature controlling element driving-circuit 45 may be switched by the control switching circuit 46, as shown in an example of FIG. 16.

In the method of controlling the optical output according to the present invention, the optical transmitting apparatus includes the direct-modulation semiconductor laser 1, the wavelength discrimination unit 110 which limits the band of modulation spectrum of an optical modulation signal to increase a wavelength-dispersion resistance and provides an optical output monitoring signal and a wavelength monitoring signal required for controlling a wavelength stabilization, the common monitor/feedback circuit 47 in which the temperature monitoring element 3 is mounted on the carrier 48 over the temperature controlling element 4 and which is capable of switching a temperature control state using the temperature monitoring element 3 and a temperature control state using a wavelength monitor signal, the control switching circuit 46, the temperature controlling element 4, the laser driving circuit 44, the CPU 42 and the memory 43.

In the method of controlling the optical output according to the present invention, in the optical transmitting apparatus, the optical output wavelength is initialized at the time of starting the optical transmitting apparatus to the wavelength longer than the optical output wavelength set in the steady state, thereafter, the semiconductor laser 1 reaches a specified optical output to be brought into the steady state without generating the optical output momentarily and significantly exceeding a specified value when it starts outputting.

The band of the optical spectrum output from the optical transmitting apparatus is limited by the band-pass filter in the above wavelength discrimination unit 110 even at a modulation rate of, for example, 10 Gbps, enabling reducing the influence of wavelength dispersion, which allows a stable transmission along a general optical fiber with a length of, for example, 80 km or more.

In the sixth exemplary embodiment, the effect of the above band-pass filter limits the optical wavelength obtained when the semiconductor laser 1 starts outputting to the vicinity of the optical wavelength set in the steady state, enabling the DWDM system to suppress the influence on adjacent channels.

Furthermore, in the sixth exemplary embodiment, a method in which the optical wavelength is initialized to the wavelength longer than the wavelength set in the steady state enables the semiconductor laser 1 to reach a specified optical output to be brought into the steady state without generating the optical output momentarily and significantly exceeding a specified value when it starts outputting.

The present invention may also be applied to an optical transmitting and receiving module in an optical transmitting system and network apparatus.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

## Claims

1. An optical transmitting apparatus comprising:
an optical filter;
a port that monitor light transmitted through the optical filter;
a port that monitor not light transmitted through the optical filter;
an optical waveguide substrate on which the optical filter and an optical waveguide which includes a port that monitors the characteristic of the light which passes through the optical filter;
a semiconductor laser; ,
a heater that is capable of independently adjust the wavelength characteristic of any of the optical waveguide and the semiconductor laser; wherein
the optical waveguide substrate and the semiconductor laser are integrated such that the temperature of the optical waveguide substrate and the semiconductor laser can be collectively adjusted.

2. The optical transmitting apparatus according to claim 1, wherein
the optical transmitting apparatus includes a temperature controlling element which can adjust the temperature of the optical waveguide substrate and the semiconductor laser collectively.

3. The optical transmitting apparatus according to claim 2, wherein
the port that monitors light transmitted through the optical filter is provided with a wavelength monitor PD (photo diode),
the port that monitors light not transmitted through the optical filter is provided with a power monitor PD, and
the temperature controlling element controls temperature adjustment so that the ratio between the outputs of the wavelength monitor PD and the power monitor PD is kept constant.

4. The optical transmitting apparatus according to any one of claims 1 to 3, wherein
the heater is controlled to be kept constant at a predetermined electric power.

5. The optical transmitting apparatus according to claim 3, wherein
electric power input to the heater is controlled with use of the outputs of the wavelength monitor PD and the power monitor PD.

6. The optical transmitting apparatus according to claim 1 or 2, further comprising:
controlling unit of initializing the optical output wavelength of the semiconductor laser at the time of starting the apparatus to the wavelength longer than the optical output wavelength set in the steady state, with the semiconductor laser directly modulated.

7. The optical transmitting apparatus according to claim 6, further comprising:
a wavelength discrimination unit that limits the band of modulation spectrum of an optical modulation signal to increase a wavelength-dispersion resistance and provides an optical output monitoring signal and a wavelength monitoring signal required for controlling a wavelength stabilization.

8. The optical transmitting apparatus according to claim 7, wherein
in the wavelength discrimination unit, the port that monitors light transmitted through the optical filter is provided with a wavelength monitor PD (Photo Diode), and the port that monitors light not transmitted through the optical filter is provided with an optical intensity monitor PD.

9. The optical transmitting apparatus according to claim 7 or 8, further comprising:
a feedback circuit that switches between a state where temperature is controlled using the temperature monitoring element and a state where temperature is controlled using the wavelength monitoring signal.

10. The optical transmitting apparatus according to claim 9, wherein
the controlling unit sets the optical output wavelength of the semiconductor laser at the time of starting the apparatus to the wavelength longer than the optical output wavelength set in the steady state, in the state where temperature is controlled using the temperature monitoring element, thereafter, the controlling unit collectively adjusts the temperature of the optical waveguide substrate and the semiconductor laser, in the state where temperature is controlled using the wavelength monitoring signal.

11. A temperature controlling method for an optical transmitting apparatus comprising:
integrating an optical waveguide substrate on which an optical waveguide including an optical filter and ports that monitor light transmitted and not transmitted through the optical filter is formed and a semiconductor laser such that the temperature of the optical waveguide substrate and the semiconductor laser can be collectively adjusted; and
adding a heater to any of the optical waveguide and the semiconductor laser to independently adjust the wavelength characteristic of any of the optical waveguide and the semiconductor laser.

12. The temperature controlling method according to claim 11, wherein
the temperature of the optical waveguide substrate and the semiconductor laser is collectively adjusted by a temperature controlling element.

13. The temperature controlling method according to claim 12, wherein
the port that monitors light transmitted through the optical filter is provided with a wavelength monitor PD (photo diode),
the port that monitors light not transmitted through the optical filter is provided with a power monitor PD, and
the temperature controlling element controls temperature so that the ratio between the outputs of the wavelength monitor PD and the power monitor PD is kept constant.

14. The temperature controlling method according to any one of claims 11 to 13, wherein
the heater is controlled to be kept constant at a predetermined electric power.

15. The temperature controlling method according to claim 13, wherein
electric power input to the heater is controlled with use of the outputs of the wavelength monitor PD and the power monitor PD.

16. The temperature controlling method according to claim 11 or 12, further comprising:
a control process for initializing the optical output wavelength of the semiconductor laser at the time of starting the optical transmitting apparatus to the wavelength longer than the optical output wavelength set in the steady state, with the semiconductor laser directly modulated.

17. The temperature controlling method according to claim 16, further comprising:
disposing a wavelength discrimination unit that limits the band of modulation spectrum of an optical modulation signal to increase a wavelength-dispersion resistance and provides an optical output monitoring signal and a wavelength monitoring signal required for controlling a wavelength stabilization.

18. The temperature controlling method according to claim 17, wherein
in the wavelength discrimination unit, the port that monitors light transmitted through the optical filter is provided with a wavelength monitor PD (Photo Diode), and the port that monitors light not transmitted through the optical filter is provided with an optical intensity monitor PD.

19. The temperature controlling method according to claim 17 or 18, further comprising:
switching between a state where temperature is controlled using the temperature monitoring element and a state where temperature is controlled using the wavelength monitoring signal.

20. The temperature controlling method according to claim 19, wherein
the controlling process sets the optical output wavelength of the semiconductor laser at the time of starting the apparatus to the wavelength longer than the optical output wavelength set in the steady state, in the state where temperature is controlled using the temperature monitoring element, thereafter, the controlling means collectively adjusts the temperature of the optical waveguide substrate and the semiconductor laser, in the state where temperature is controlled using the wavelength monitoring signal.
